# EUROPÄISCHE PATENTANMELDUNG

(11) **EP 4 102 724 A1**
(43) Veröffentlichungstag der Anmeldung: **14.12.2022**
(21) Anmeldenummer: 21177922.8
(22) Anmeldetag: 07.06.2021
(51) Int. Cl.: H03K 17/96, H03K 17/965

(54) **SCHALT-VORRICHTUNG**

(71) Anmelder: RAFI GmbH & Co. KG, 88276 Berg (DE)
(72) Erfinder: Elbs, Alexander, 88097 Eriskirch (DE); Mennig, Sebastian, 88353 Kißlegg (DE); Fleischer, Frank, 88368 Bergatreute (DE); Voth, Michael, 88214 Ravensburg (DE)
(74) Vertreter: Christ, Niko

(57) **Zusammenfassung**

Bei einer Schalt-Vorrichtung (1) als Schnittstelle zwischen Menschen und Maschinen bzw. sonstigen elektrischen Geräten (20) zur Umwandlung einer manuellen und/oder mechanischen Zustellbewegung (2, 3, 4) in mindestens ein Schaltsignal, durch das das elektrische Gerät (20) gesteuert wird, bestehend aus einem Gehäuse (5), in das mindestens eine Aufnahmeöffnung (6) eingearbeitet ist, mindestens einer in einer der Aufnahmeöffnungen (6) eingesetzten Bedienkappe (7), die entlang einer Zustellrichtung (8) bewegbar ist, soll eine berührungslose und/oder eine berührende Schaltausübung und/oder eine mechanisch erzeugte Schaltung von jedem Benutzer individuell ausgewählt werden können. Dies ist dadurch erreicht, dass die Bedienkappe (7) einen Schichtaufbau (11) aufweist, der aus mindestens drei Lagen (12, 13, 14) besteht, dass die erste Lage (12) die Außenseite der Bedienkappe (7) bildet und als Betätigungsfläche dient, dass die zweite Lage (13) als elektrisch isolierende Folie oder Schicht ausgestaltet ist, dass die dritte Lage (14) als kapazitiver Flächensensor ausgebildet ist, durch den ein räumlich wirkendes elektrisches Feld (15) durch die beiden darüber angeordneten Lagen (12, 13) auf die Außenseite der Bedienkappe (7) abgestrahlt ist, dass der Flächensensor (14) mit einer Auswerteeinheit (16) elektrisch verbunden ist, durch die das elektrische Feld (15) überwacht und bei einer Veränderung des elektrischen Feldes (15) ein Schaltsignal generiert ist, dass auf der Unterseite des Flächensensors (14) ein von diesem abstehender Stößel (18) vorgesehen ist, dass im Inneren des Bediengehäuses (9) ein Mikrotaster (21) angeordnet ist, der elektrisch mit der Auswerteeinheit (16) verbunden ist, und dass der Stößel (18) und der Mikrotaster (21) fluchtend zueinander angeordnet sind und beim Bewegen der Bedienkappe (7) der Stößel (18) auf den Mikrotaster (21) gedrückt ist, derart, dass eine Schaltbewegung in dem Mikrotaster (21) erzeugt ist, die von der Auswerteeinheit (16) feststellbar und in ein elektrisches Schaltsignal unwandelbar ist.

## Beschreibung

Die Erfindung bezieht sich auf eine Schalt-Vorrichtung als Schnittstelle zwischen Mensch und Maschinen bzw. sonstigen elektrischen Geräten zur Umwandlung einer mechanischen und/oder manuellen Zustellbewegung in mindestens ein Schaltsignal, durch das das elektrische Gerät bzw. die Maschine gesteuert wird nach dem Oberbegriff des Patentanspruches 1.

Solche Schalt-Vorrichtungen sind beispielsweise der DE 10 2010 006 777 B4 als sogenannter kapazitiver Berührungs- und/oder Annäherungsschalter mit einer Abdeckplatte zu entnehmen. Die dem Benutzer zugewandte Seite weist ein Berührungsfeld auf. Sobald ein geerdetes Objekt, beispielsweise ein menschlicher Finger, in das Berührungsfeld eintaucht, verändert sich die Spannung des elektrischen Feldes. Solche Veränderungen sind durch eine Auswerteeinrichtung feststellbar, sodass hierdurch ein elektrisches Schaltsignal generierbar ist.

Nachteiliger Weise sind solche Schalt-Vorrichtungen dafür ausgelegt, dass diese die Veränderung des elektrischen Feldes messen und demnach keine axialen Bewegungen ausführen bzw. solche axialen Bewegungen sind nicht vorgesehen, da die kapazitive Messung eine solche nicht benötigt. Folglich weisen solche Schalt-Vorrichtungen keine wahrnehmbare Schalthaptiken auf und ein spürbares Schalten findet nicht statt.

Bei der EP 2 559 164 B1 dient eine Benutzerschnittstelle mit einer kapazitiven Messschaltung, die ein Messplattengebilde aufweist, dazu, von einem elektrisch leitfähigen Abdeckelement eine elektrisch ausführbare Schaltung zur Verfügung zu stellen. Dabei ist eine Betätigungskraft auf das leitfähige Abdeckungselement auszuüben oder eine an dem leitfähigen Abdeckelement angebrachte Materialschicht ist durch die Betätigungskraft in der räumlichen Abmessung zu verändern, sodass der Abstand zwischen der Messplatte und dem leitfähigen Abdeckungselement verändert ist, wodurch eine Veränderung des elektrischen Feldes der Messschaltung erzeugt ist.

Nachteiliger Weise ist die aufzuwendende Betätigungskraft derart zu bemessen bzw. auszuüben, dass eine ausreichende Abstandsveränderung erzeugt ist und eine Schalthaptik ist nicht gegeben.

Darüber hinaus sind eine Vielzahl von Mikrotastern bekannt, die durch eine manuelle und/oder maschinelle Zustellbewegung zu aktivieren sind. Solche Mikrotaster bestehen üblicherweise aus zwei zueinander beabstandeten elektrischen Kontakten, die beim Betätigen des Mikrotasters elektrisch miteinander verbunden sind, sodass ein messbarer Kurzschluss entsteht. Sobald demnach die vorhandenen Kontaktelemente kurzgeschlossen sind, entsteht ein Schaltsignal.

Es ist bislang nicht bekannt, eine mechanische Schaltung mit einer kapazitiv auswertbaren Schaltung zu verbinden.

Es ist Aufgabe der Erfindung, eine Schalt-Vorrichtung der eingangs genannten Gattung derart weiterzubilden, dass zum einen eine berührungslose und/oder eine berührende Schaltauslösung und/oder eine mechanisch erzeugte Schaltung von jedem Benutzer individuell ausgewählt werden kann, ohne dass hierfür die Programmierung und/oder der konstruktive Aufbau der Schalt-Vorrichtung zu verändern ist, und zum anderen soll jede vorgenommene Anwendung den Schaltvorgang auslösen und/oder freigeben.

Diese Aufgabe ist durch die Merkmale des kennzeichnenden Teils von Patentanspruch 1 gelöst.

Weitere vorteilhafte Weiterbildungen der Erfindung ergeben sich aus den Unteransprüchen.

Dadurch, dass die Bedienkappe einen Schichtaufbau aufweist, der aus mindestens drei Lagen besteht, dass die erste Lage die Außenseite der Bedienkappe bildet und als Betätigungsfläche dient, dass die zweite Lage als elektrisch isolierende Folie oder Schicht ausgestaltet ist, dass die dritte Lage als kapazitiver Flächensensor ausgebildet ist, durch den ein räumlich wirkendes elektrisches Feld durch die beiden darüber angeordneten Lagen auf die Außenseite der Bedienkappe abgestrahlt ist, dass der Flächensensor mit einer Auswerteeinheit elektrisch verbunden ist, durch die das elektrische Feld überwacht und bei einer Veränderung des elektrischen Feldes ein Schaltsignal generiert ist, dass auf der Unterseite des Flächensensors ein von diesem abstehender Stößel vorgesehen ist, dass im Inneren des Schaltgehäuses ein Mikrotaster angeordnet ist, der elektrisch mit der Auswerteeinheit verbunden ist, und dass der Stößel und der Mikrotaster fluchtend zueinander angeordnet sind und beim Bewegen der Bedienkappe der Stößel auf den Mikrotaster gedrückt ist, derart, dass eine Schaltbewegung in dem Mikrotaster erzeugt ist, die von der Auswerteeinheit feststellbar und in ein elektrisches Schaltsignal umwandelbar ist, kann mit jedem Schaltvorgang der Benutzer individuell entscheiden, ob der Schaltvorgang durch eine berührungslose Zustellbewegung zu betätigen ist und/oder ob eine Bewegung auf der Oberfläche der Bedienkappe zur Schaltauslösung und/oder ob eine Betätigung des Mikrotasters durch Herunterdrücken der Bedienkappe zur Generierung des Schaltsignals verwendet werden soll. Insbesondere zur Vermeidung von Kontaktflächen, die von einer Vielzahl von unterschiedlichen Benutzern berührt werden, ist es oftmals wünschenswert, wenn keine unmittelbare Berührung zwischen der Fingerkuppe eines menschlichen Fingers und der Bedienkappe zu erfolgen hat, um das Schaltsignal zu generieren. Es gibt jedoch oftmals die Notwendigkeit, ein Schaltsignal durch eine lineare Bewegung zu erzeugen, wenn beispielsweise damit eine bestimmte Steuerung verbunden ist. Ferner besteht in manchen Betriebssituationen nicht die Möglichkeit, die Betätigung der Bedienkappe visuell zu überwachen, sodass es ebenso erforderlich sein könnte, eine Schalthaptik durch die Betätigung eines Mikrotasters bereitzustellen.

Mittels der erfindungsgemäßen Ausgestaltung der Schalt-Vorrichtung kann jeder Benutzer nunmehr individuell entscheiden, welche der drei Bedienmöglichkeiten verwendet werden sollen. Dies erfolgt unabhängig von dem Aufbau der Schalt-Vorrichtung oder deren Programmierung, denn die drei Bedienmöglichkeiten können völlig unabhängig oder sogar gleichzeitig durchgeführt sein.

In der Zeichnung ist eine erfindungsgemäße Schalt-Vorrichtung dargestellt, die nachfolgend näher erläutert ist. Im Einzelnen zeigt:
- Figur 1: eine Schalt-Vorrichtung, bestehend aus zwölf Bedienkappen, die in einem Gehäuse axial fest montiert eingesetzt sind und die jeweils ein Bedienfeld zur Erzeugung eines vorgegebenen Schaltsignals bilden, in perspektivischer Ansicht,
- Figur 2: die Schalt-Vorrichtung gemäß Figur 1, im Schnitt, mit drei unterschiedlichen Betätigungsmöglichkeiten für die jeweilige Bedienkappe,
- Figur 3: eine der Bedienkappen gemäß Figur 2, in perspektivischer Ansicht,
- Figur 4: einen Teil der Bedienkappe gemäß Figur 3, ohne Schaltgehäuse und mit elektrischen Anschlüssen, in der ein Mikrotaster vorgesehen ist,
- Figur 5: die Bedienkappe gemäß Figur 3, im Schnitt, mit einem dreischichtigen Aufbau der Bedienkappe und deren Lagerung in dem Gehäuse sowie mit den elektrischen Schaltkomponenten zur Erzeugung des jeweiligen Schaltsignals im unbetätigten Ausgangszustand,
- Figur 6a: die Bedienkappe gemäß Figur 5, mit einer berührungslosen Annäherung eines geerdeten Objektes in Richtung der Oberseite der Bedienkappe,
- Figur 6b: die Bedienkappe gemäß Figur 5, mit einer manuellen Zustellbetätigung der Bedienkappe durch das geerdete Objekt,
- Figur 7: die für die Erzeugung des jeweiligen elektrischen Schaltsignals erforderliche elektrische Schaltung zur Auswertung der Bedienkappe gemäß Figur 3 und
- Figur 8: einen schematischen Ablaufplan zur Auswertung der jeweiligen Betätigung der Bedienkappe gemäß Figur 3 .

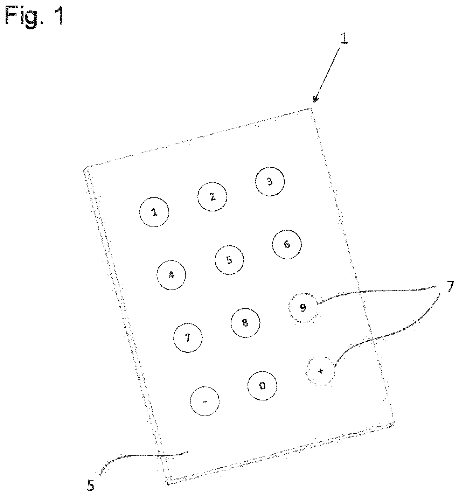

Aus Figur 1 ist eine Schalt-Vorrichtung 1 zu entnehmen, durch die eine Schnittstelle zwischen Menschen und Maschinen bzw. sonstigen elektrischen Geräten 20 zur Umwandlung einer manuellen und/oder maschinellen Zustellbewegung 2, 3 oder 4 in mindestens ein Schaltsignal abgebildet ist. Die Schalt-Vorrichtung 1 umfasst beispielhaft zwölf Bedienkappen 7, die jeweils eine bestimmte Schaltfunktion in Form eines Bedienfeldes definieren. Die jeweilige Schaltfunktion ist auf der Oberseite der Bedienkappe 7 aufgedruckt oder mittels Lichtstrahlung oder sonstigen elektrischen Maßnahmen von außen zu erkennen, sodass jeder Benutzer der Schalt-Vorrichtung 1 von außen visuell erkennt, welche Bedienkappe 7 mit welcher Schaltfunktion versehen ist.

Die jeweilige Bedienkappe 7 ist dabei in einem Gehäuse 5 angeordnet. Zur Aufnahme der jeweiligen Bedienkappe 7 ist in dem Gehäuse 5 eine Aufnahmeöffnung 6 eingearbeitet. Die jeweilige Bedienkappe 7 weist zudem ein ringförmiges Bediengehäuse 9 auf, das in der Aufnahmeöffnung 6 des Gehäuses 5 eingesetzt ist.

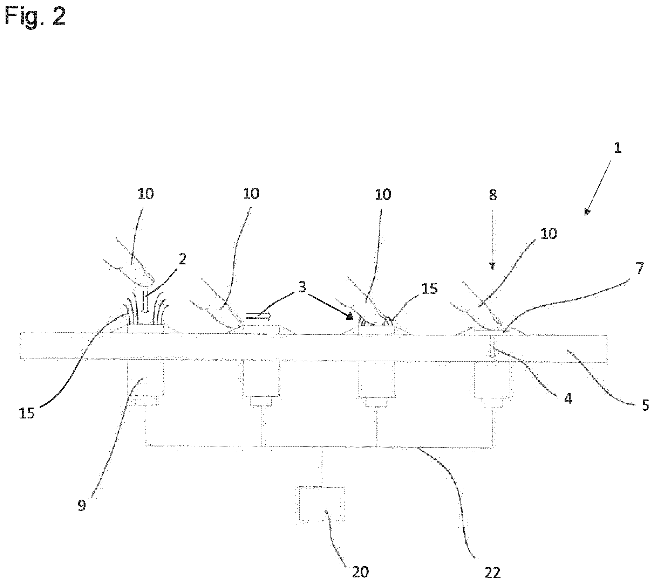

In Figur 2 sind drei unterschiedliche Betätigungsmöglichkeiten für die jeweilige Bedienkappe 7 zu entnehmen. Zum einen kann nämlich die Bedienkappe 7 mittels einer berührungslosen Zustellbewegung 2 oder mit einer die Oberfläche der Bedienkappe 7 berührenden und auf diesen entlang streichenden Zustellbewegung 3 und/oder mit einer drückenden Zustellbewegung 4 zur Erzeugung eines entsprechenden der Bedienkappe 7 zugeordneten Schaltsignals betätigt sein. Durch die drückende Zustellbewegung 4 ist die Bedienkappe 7 in das Bediengehäuse 9 eingedrückt. Die jeweilige Betätigung der Bedienkappe 7 erfolgt über ein geerdetes Objekt 10, beispielsweise einen menschlichen Finger.

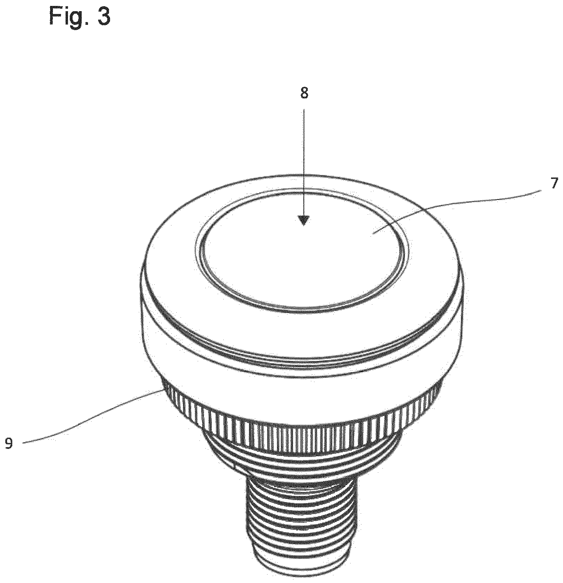

Gemäß Figur 3 weist jede der Bedienkappen 7 das ringförmige Bediengehäuse 9 auf, in dem die Bedienkappe 7 axial beweglich gelagert ist. Das Bediengehäuse 9 ist in die Aufnahmeöffnung 6 einzusetzen.

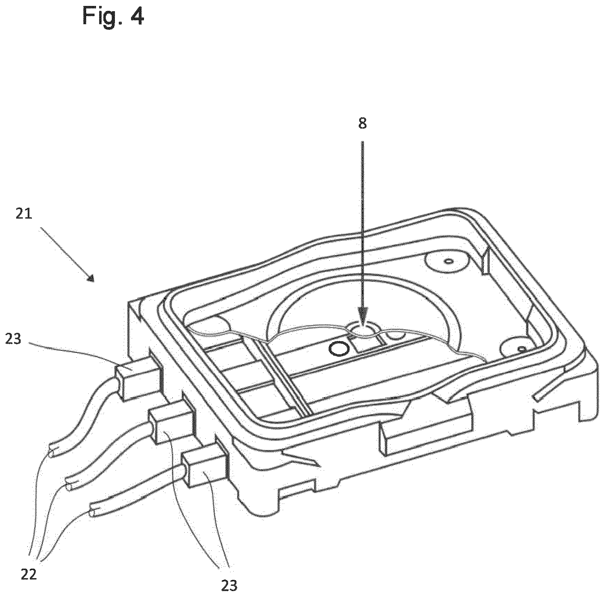

In Figur 4 ist der konstruktive Aufbau eines Teils der jeweiligen Bedienkappe 7 zu entnehmen. Im Inneren des jeweiligen Bediengehäuses 9 ist dabei ein Mikrotaster 21 angeordnet, der mechanisch durch die Zustellbewegung 4 zu betätigen ist. Der Mikrotaster 21 weist eine vorgegebene und durch das Objekt 10 wahrnehmbare Schalthaptik auf. Beispielsweise ist dem Mikrotaster 21 eine Schnappscheibe oder ein sonstiger mechanischer Schaltmechanismus zugeordnet, durch den akustische und fühlbare Schalthaptiken zugeordnet sind. Durch die Betätigung des Mikrotasters 21 werden zwei in diesem vorgesehene elektrische Schaltkontakte kurzgeschlossen, wodurch das Schaltsignal generiert ist. Die entsprechenden elektrischen Schaltkontakte sind mittels elektrischer Leitungen 22 und mit elektrischen Steckern 23 an weitere nachfolgend näher erläuterte elektrische Komponenten angeschlossen oder mit dem Gerät 20 verbunden.

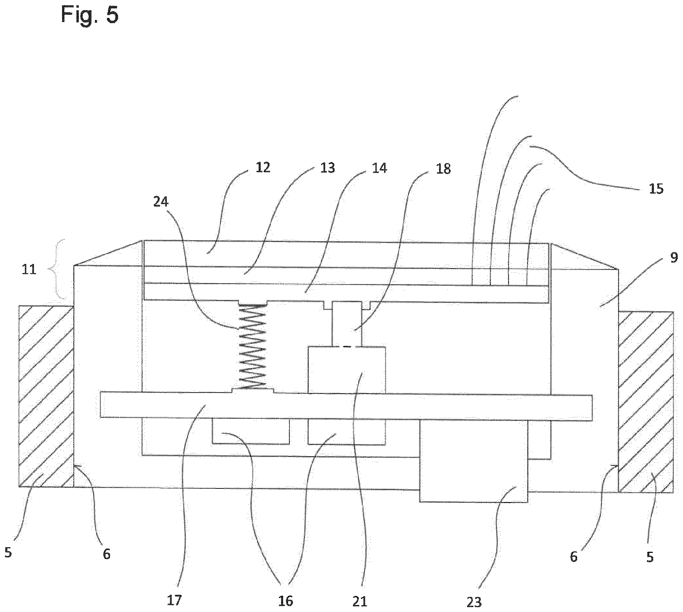

Aus Figur 5 ist der konstruktive und elektrische Aufbau der jeweiligen Bedienkappe 7 zu entnehmen. Zunächst umfasst die Bedienkappe 7 einen dreischichtigen Schichtaufbau 11, der aus drei Lagen 12, 13 und 14 besteht und dabei als dünnwandige und fest miteinander verbundene Folien oder Träger-Schichten ausgestaltet sind. Die erste Lage 12 ist der Außenseite der Bedienkappe zugeordnet und kann von dem geerdeten Objekt 10 berührt werden. Die darunter angeordnete zweite Lage 13 ist als Folie oder Träger-Schicht ausgestaltet und dient als Trägerschicht. Gleichzeitig wirkt die Folie 13 elektrisch isolierend. Die weiter darunter angeordnete dritte Lage 14 ist als Flächensensor ausgestaltet, durch den ein elektrisches Feld 15 durch die beiden darüber verlaufenden Lagen 12 und 13 auf die Außenseite der Bedienkappe 7 abgestrahlt ist und demnach eine räumliche Ausdehnung aufweist.

Der kapazitive Flächensensor 14 ist dabei mit einer Auswerteeinheit 16, beispielsweise in Form eines Mikroprozessors, verbunden. Darüber hinaus ist der Auswerteeinheit 16 eine Leiterplatte 17 zugeordnet, durch die zum einen die elektrische Verschaltung sämtlicher elektrischer Komponenten im Inneren der Bedienkappe 7 angeordnet sind und zum anderen soll die Leiterplatte 17 als Trägerelement für sämtliche der erforderlichen elektrischen Komponenten dienen.

Um den Flächensensor 14 zu bestromen, sodass das elektrische Feld 15 erzeugt ist, ist der Flächensensor 14 über eine elektrische Leitung 24 mit der Leiterplatte 17 verbunden. Diese elektrische Leitung 24 ist vorteilhafter Weise in Form einer Spiralfeder ausgestaltet, sodass diese bei der axialen Zustellbewegung 4 der jeweiligen Bedienkappe 7 zusammengedrückt ist und folglich eine Vorspann- oder Rückstellkraft entsteht bzw. gespeichert ist. Eine weitere Funktion der Feder 24 besteht darin, den elektrischen Kontakt zwischen dem Flächensensor 14 und der Auswerteeinrichtung 16 dauerhaft herzustellen.

Darüber hinaus ist an der Unterseite des Flächensensors 14 ein Stößel 18 vorgesehen, der mit dem auf der Leiterplatte 17 befestigten Mikrotaster 21 zusammenwirkt. Sobald nämlich die Bedienkappe 7 und damit der Stößel 18 in Richtung des Mikrotasters 21 durch die axiale Zustellbewegung 4 gedrückt ist, wirkt die dem Mikrotaster 21 zugewandte Unterseite des Stößels 18 auf den Mikrotaster 21 ein, wodurch die beiden dem Mikrotaster 21 zugeordneten elektrischen Kontakte kurzgeschlossen sind und das elektrische Schaltsignal generiert ist. Sobald die manuelle Zustellkraft auf die Bedienkappe 7 nicht mehr einwirkt, drückt die elektrische Leitung 24 in Form der Spiralfeder die Bedienkappe 7 wieder in die Ausgangsposition gemäß Figur 5 zurück. Das übernimmt bereits die Rückstellkraft der Schnappscheibe im Mikrotaster.

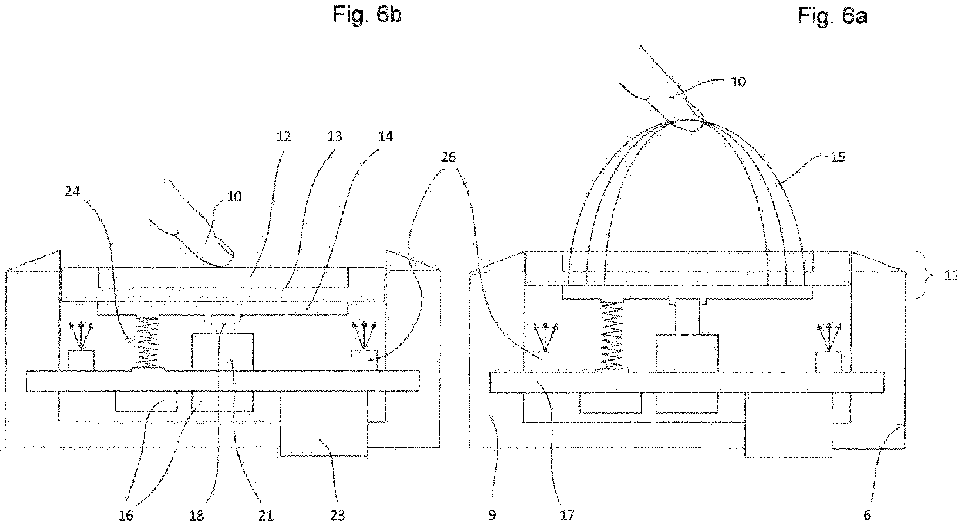

In Figur 6a ist gezeigt, dass durch das Eindringen des geerdeten Objektes 10 das elektrische Feld 15 des Flächensensors 14 verändert ist. Diese Veränderung des elektrischen Feldes 15 ist durch die Auswerteeinheit 16 feststellbar und sobald ein vorprogrammierter oder vorgegebener Schwellwert überschritten ist, generiert die Auswerteeinheit 16 das der Veränderung des elektrischen Feldes 15 zugeordnete Schaltsignal.

Gemäß Figur 6b kann das geerdete Objekt 10 die Bedienkappe 7 axial in Richtung des Mikrotasters 21 bewegen, wodurch zusätzlich der Mikrotaster 21 betätigt ist und ein zusätzliches oder unabhängiges Schaltsignal zu der Veränderung des elektrischen Feldes 15 erzeugt ist.

Vorteilhafterweise können die Innenräume des Schaltgehäuses 9 mittels LED 26 ausgeleuchtet sein. Die drei Lagen 12, 13 und 14 können nämlich transparent, also lichtdurchlässig, sein.

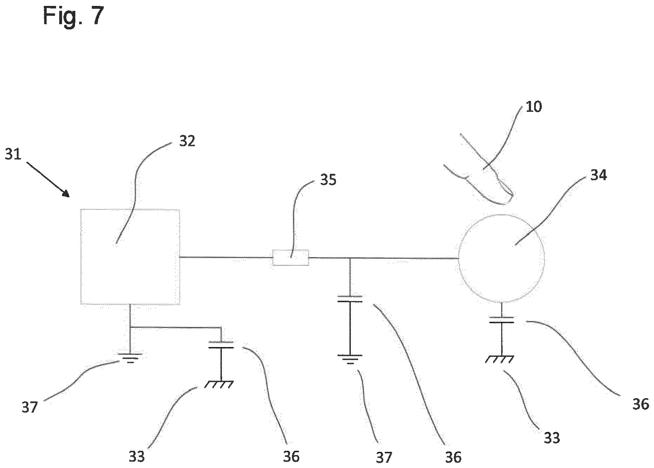

In Figur 7 ist schematisch ein elektrischer Aufbau einer elektrischen Schaltung 31 zu entnehmen. Dabei ist eine Spannungsquelle 32 vorgesehen, durch die sämtliche elektrische Komponenten mit der erforderlichen Spannung versorgt sind. Die Erdung der elektrischen Schaltung 31 ist mit der Bezugsziffer 33 gekennzeichnet. Der in der Schaltung 31 vorgesehene Berührungssensor 34 entspricht dem Flächensensor 14. Die erforderlichen Widerstände sind mit der Bezugsziffer 35, die notwendigen Kondensatoren mit der Bezugsziffer 36 und die Bezugsmasse mit der Bezugsziffer 37 gekennzeichnet. Sobald demnach eine berührungslose Zustellbewegung 2 erfolgt, erkennt dies der Berührungssensor 34, wodurch das entsprechende Schaltsignal generiert ist. Auch ein Entlangstreichen auf der Oberseite der Bedienkappe 7 wird von dem Berührungssensor 34 erfasst und in ein elektrisches Schaltsignal umgewandelt. Gleiches gilt für die drückende Zustellbewegung 4 beim Betätigen des Mikrotasters 21. Sämtliche der drei möglichen Zustellbewegungen 2, 3 und/oder 4 sind unabhängig voneinander ausführbar, da diese ausschließlich von einem eingestellten Schwellwert in der Auswerteeinheit 16 abhängen. Gleichwohl soll durch eine entsprechende Programmierung der Auswerteeinheit 16 die jeweilige Generierung des Schaltsignals auf eine der drei Zustellbewegungen 2, 3 oder 4 begrenzt sein.

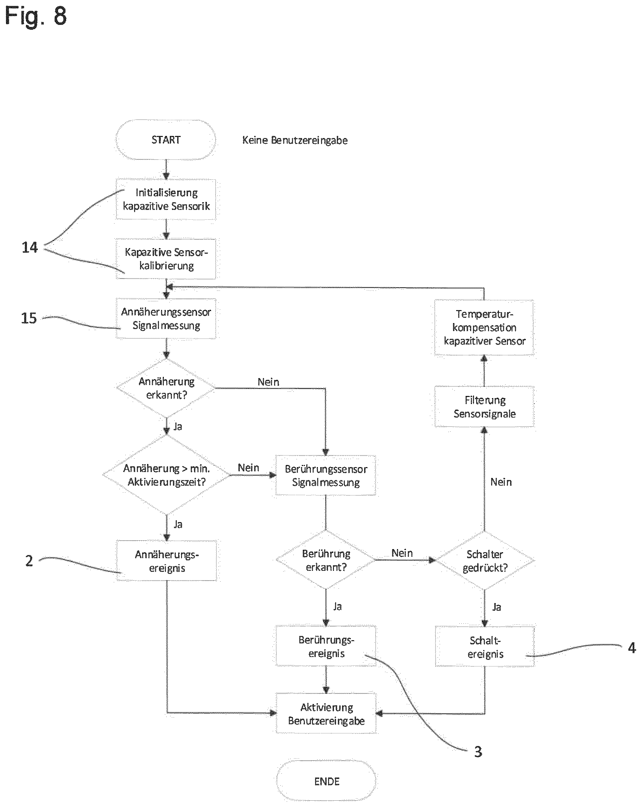

Aus Figur 8 ist ein schematischer Schaltablauf bzw. Betätigungsablauf der Schalt-Vorrichtung 1 zu entnehmen. Sobald die Schalt-Vorrichtung 1 eingeschaltet ist, kann die jeweilige Bedienkappe 7 durch Initialisierung des Flächensensors 14 und dessen Kalibrierung erfolgen. Durch die permanente Auswertung des elektrischen Feldes 15 durch die Auswerteeinrichtung 16 erfolgt eine Überwachung der Veränderung des elektrischen Feldes 15. Wenn eine solche Veränderung des elektrischen Feldes 15 festgestellt ist, kann bereits ein Schaltsignal generiert sein oder der Schwellwert für die Veränderung des elektrischen Feldes 15 ist derart vorgegeben, dass durch die Annäherung des geerdeten Objektes 10 lediglich die Freischaltung der Schalt-Vorrichtung 1 erfolgt. Darüber hinaus kann auch die Dauer Δ t der Veränderung des elektrischen Feldes 15 durch die Auswerteeinrichtung 16 überwacht sein. Auch bei der Messung der Zeitspanne, innerhalb der das elektrische Feld 15 verändert ist, können entsprechende Schwellwerte in der Auswerteeinrichtung 16 eingegeben sein, wodurch unterschiedliche Schaltauslösesignale generierbar sind. Dies führt dazu, dass dann auch tatsächlich feststellbar ist, ob eine berührende Zustellbewegung 3 erfolgt bzw. ob der Mikrotaster 21 durch die axiale Zustellbewegung 4 aktiviert wurde.

Gemäß des Schaltablaufplans der Figur 8 ist gezeigt, dass die drei unterschiedlichen Zustellbewegungen 2, 3 und 4 unabhängig voneinander oder gemeinsam ein entsprechendes Schaltsignal auslösen können. Somit ist von jedem Benutzer der erfindungsgemäßen Schalt-Vorrichtung 1 frei zu entscheiden, welche der drei Zustellbewegungen 2, 3 oder 4 vorzusehen bzw. gewünscht ist.

## Patentansprüche

1. Schalt-Vorrichtung (1) als Schnittstelle zwischen Menschen und Maschinen bzw. sonstigen elektrischen Geräten (20) zur Umwandlung einer manuellen und/oder mechanischen Zustellbewegung (2, 3, 4) in mindestens ein Schaltsignal, durch das das elektrische Gerät (20) gesteuert wird, bestehend aus:
- einem Gehäuse (5), in das mindestens eine Aufnahmeöffnung (6) eingearbeitet ist,
- mindestens einer in einer der Aufnahmeöffnungen (6) eingesetzten Bedienkappe (7), die entlang einer Zustellrichtung (8) bewegbar ist,
**dadurch gekennzeichnet,**
**dass** die Bedienkappe (7) einen Schichtaufbau (11) aufweist, der aus mindestens drei Lagen (12, 13, 14) besteht, dass die erste Lage (12) die Außenseite der Bedienkappe (7) bildet und als Betätigungsfläche dient, dass die zweite Lage (13) als elektrisch isolierende Folie oder Schicht ausgestaltet ist, dass die dritte Lage (14) als kapazitiver Flächensensor ausgebildet ist, durch den ein räumlich wirkendes elektrisches Feld (15) durch die beiden darüber angeordneten Lagen (12, 13) auf die Außenseite der Bedienkappe (7) abgestrahlt ist, dass der Flächensensor (14) mit einer Auswerteeinheit (16) elektrisch verbunden ist, durch die das elektrische Feld (15) überwacht und bei einer Veränderung des elektrischen Feldes (15) ein Schaltsignal generiert ist, dass auf der Unterseite des Flächensensors (14) ein von diesem abstehender Stößel (18) vorgesehen ist, dass im Inneren des Bediengehäuses (9) ein Mikrotaster (21) angeordnet ist, der elektrisch mit der Auswerteeinheit (16) verbunden ist, und dass der Stößel (18) und der Mikrotaster (21) fluchtend zueinander angeordnet sind und beim Bewegen der Bedienkappe (7) der Stößel (18) auf den Mikrotaster (21) gedrückt ist, derart, dass eine Schaltbewegung in dem Mikrotaster (21) erzeugt ist, die von der Auswerteeinheit (16) feststellbar und in ein elektrisches Schaltsignal unwandelbar ist.

2. Schalt-Vorrichtung nach Anspruch 1,
**dadurch gekennzeichnet,**
**dass** die Unterseite des Stößels (18) im Ausgangszustand der Bedienkappe (7) beabstandet zu der Oberfläche des Mikrotasters (21) angeordnet ist oder dass der Stößel (18) auf dem Mikrotaster (21) aufliegt und dass die Wegstrecke der Zustellbewegung der jeweiligen Bedienkappe (7) aus der Summe der Wegstrecken des Stößels (18) und des Betätigungsweges des Mikrotasters (21) entspricht.

3. Schalt-Vorrichtung nach Anspruch 1 oder 2,
**dadurch gekennzeichnet,**
**dass** in der Auswerteeinrichtung (16) unterschiedliche Schwellwerte vorgegeben oder einprogrammiert sind, durch die bei der Annäherung eines geerdeten Objektes (10) in das elektrische Feld (15) des Flächensensors (14) das Schaltsignal ausgelöst ist, und/oder dass der eingestellte Schwellwert überschritten ist sobald ein geerdetes Objekt (10) entlang der Oberfläche der ersten Lage (12) bewegt ist, und/oder dass der eingestellte Schwellwert überschritten ist, sobald der Mikrotaster (21) durch den Stößel (18) von dem Ausgangszustand in den Schaltzustand gedrückt ist.

4. Schalt-Vorrichtung nach Anspruch 3,
**dadurch gekennzeichnet,**
**dass** die in der Auswerteeinrichtung (16) eingegebenen Schwellwerte unabhängig voneinander auslösbar sind.

5. Schalt-Vorrichtung nach einem der vorgenannten Ansprüche,
**dadurch gekennzeichnet,**
**dass** in den jeweiligen Mikrotaster (21) eine Schnappscheibe oder ein mechanischer und/oder elektrischer Mechanismus vorgesehen ist, durch die oder durch den eine akustisch wahrnehmbare Schalthaptik und/oder eine fühlbare Schalthaptik entsteht, derart, dass der jeweilige Benutzer der Bedienkappe (7) die Betätigung des Mikrotaster (21) wahrnimmt.

6. Schalt-Vorrichtung nach einem der vorgenannten Ansprüche,
**dadurch gekennzeichnet,**
**dass** der Flächensensor (14) mittels einer elektrischen Leitung (22) an der Auswerteeinrichtung (16) elektrisch verbunden ist, dass die elektrische Leitung als Spiraldruckfeder ausgestaltet ist, und dass die Spiraldruckfeder (24) zwischen dem Flächensensor (14) und einer in dem Bediengehäuse (9) eingebauten Leiterplatte (17) angeordnet ist.
